(19) Europäisches Patentamt
European Patent Office
Office européen des brevets

(11) Veröffentlichungsnummer: **0 298 033**
**A2**

# (12) EUROPÄISCHE PATENTANMELDUNG

(21) Anmeldenummer: **88810429.6**

(22) Anmeldetag: **22.06.88**

(51) Int. Cl.[4]: **C 08 K 5/09**
C 08 L 63/00, G 03 C 1/00,
G 03 F 7/00

(30) Priorität: **01.07.87 CH 2485/87**

(43) Veröffentlichungstag der Anmeldung:
**04.01.89 Patentblatt 89/01**

(84) Benannte Vertragsstaaten:
**CH DE FR GB LI NL**

(71) Anmelder: **CIBA-GEIGY AG**
**Klybeckstrasse 141**
**CH-4002 Basel (CH)**

(72) Erfinder: **Fischer, Walter, Dr.**
**Vogesenstrasse 77**
**CH-4153 Reinach (CH)**

**Finter, Jürgen, Dr.**
**Zasiusstrasse 100**
**D-7800 Freiburg (DE)**

## (54) Lichtempfindliche Epoxidharze und deren Verwendung.

(57) Härtbare Zusammensetzung, enthaltend a) ein Epoxidharz, b) gegebenenfalls einen Härter, c) ein Anthrachinon der Formel I

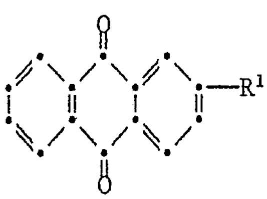

(I),

worin $R^1$ -COOH oder ein Rest der Formel II

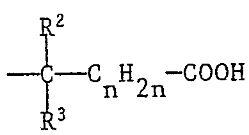

(II)

ist, in dem n 0 oder eine Zahl von 1 bis 12 bedeutet, $R^2$ H, $C_1$-$C_{12}$-Alkyl oder -CN ist und $R^3$ für H, -CN oder den Rest -$C_mH_{2m}X$ steht, m 0 oder eine Zahl von 1 bis 12 ist, und X -COOH oder -CN bedeutet, und d) einen Aminoalkohol. Die gehärteten Zusammensetzungen sind lichtempfindlich und eignen sich zur Herstellung von metallischen Ueberzügen und Abbildungen durch stromlose Metallabscheidung.

EP 0 298 033 A2

**Beschreibung**

## Lichtempfindliche Epoxidharze und deren Verwendung

Die vorliegende Erfindung betrifft eine härtbare Zusammensetzung, enthaltend a) ein Epoxidharz, b) gegebenenfalls einen Härter, c) eine Anthrachinoncarbonsäure, d) einen Aminoalkohol; die Verwendung der lichtempfindlichen gehärteten Zusammensetzung zur Herstellung von metallischen Ueberzügen und Abbildungen durch stromlose Metallabscheidung, und mit Anthrachino-2-yl substituierte aliphatische Dicarbonsäuren.

In der EP-A-0 112 798 sind lichtempfindliche, vernetzte Reaktionsprodukte auf der Basis von Epoxidharzen beschrieben. Unter Mitverwendung von Metallsalzen der Gruppen Ib oder VIII des Periodensystems der Elemente können durch Belichtung Metallkeime erzeugt werden, die man durch stromlose Metallabscheidung verstärken kann. Es ist wünschenswert, auf lichtempfindlichen Epoxidharzen direkt und ohne Mitverwendung von Metallsalzen metallische Ueberzüge oder Abbildungen durch stromlose Metallabscheidung zu erzeugen.

Ein Gegenstand der Erfindung ist eine härtbare Zusammensetzung, enthaltend

a) mindestens ein Epoxidharz mit durchschnittlich mehr als einer Epoxidgruppe im Molekül,

b) gegebenenfalls einen Härter für das Epoxidharz,

c) mindestens ein Anthrachinon der Formel I

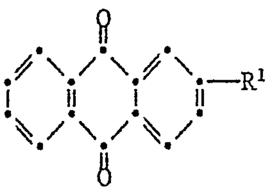

(I),

worin $R^1$ -COOH oder ein Rest der Formel II

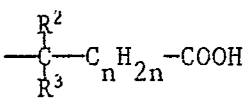

(II)

ist, in dem n 0 oder eine Zahl von 1 bis 12 bedeutet, $R^2$ H, $C_1$-$C_{12}$-Alkyl oder -CN ist und $R^3$ für H, -CN oder den Rest $-C_mH_{2m}X$ steht, m 0 oder eine Zahl von 1 bis 12 ist, und X -COOH oder -CN bedeutet, und

d) mindestens ein primäres oder sekundäres aliphatisches Amin, das im aliphatischen Rest mindestens eine Hydroxylgruppe enthält.

Bei $R^2$ in der Bedeutung von Alkyl kann es sich um lineares oder verzweigtes Alkyl handeln, das bevorzugt 1 bis 6 C-Atome enthält. Beispiele sind Methyl, Ethyl, n- und i-Propyl, n-, i- und t-Butyl, Pentyl, Hexyl, 2-Ethylhexyl, Heptyl, Octyl, Decyl and Dodecyl.

Bei den $C_mH_{2m}$- und $C_nH_{2n}$-Gruppen kann es sich um lineares oder verzweigtes Alkylen handeln. Wenn $m > 0$ und $n > 0$ sind, handelt es sich bevorzugt um identische Alkylengruppen. Insbesondere stellen m und n 0 oder eine Zahl von 1 bis 6 dar. Beispiele für Alkylen sind besonders Methylen und Ethylen sowie 1,2- oder 1,3-Propylen, 1,2-, 1,3- oder 1,4-Butylen, 1,2-, 1,3-, 1,4- oder 1,5-Pentylen, 1,2-, 1,3-, 1,4-, 1,5- oder 1,6-Hexylen, 2-Ethyl-1,6-Hexylen, Heptylen, Nonylen, Decylen, Undecylen und Dodecylen.

Eine bevorzugte Ausführungsform, ist eine Zusammensetzung, worin in Formel I $R^1$ -COOH oder ein Rest der Formel II ist, in dem $R^2$ H, $C_1$-$C_6$-Alkyl oder -CN darstellt, $R^3$ für H, oder den Rest $-C_mH_{2m}X$ steht, X -COOH bedeutet, und m und n unabhängig voneinander 0 oder eine Zahl von 1 bis 6 sind. Insbesondere sind in dieser Zusammensetzung m und n unabhängig voneinander 0 oder eine Zahl von 1 bis 4.

Eine besonders bevorzugte Ausführungsform ist eine Zusammensetzung, worin $R^1$ -COOH oder ein Rest der Formel II ist, in dem $R^2$ H, Methyl, Ethyl oder -CN darstellt, $R^3$ H oder den Rest $-C_mH_{2m}COOH$ bedeutet, und m und n unabhängig voneinander für 0, 1, 2 oder 3 stehen.

Die Anthrachinone der Formel I sind teilweise bekannt oder können nach an sich bekannten Verfahren hergestellt werden. Mit Anthrachino-2-yl substituierte Carbonsäuren können durch die Umsetzung von Alkencarbonsäureestern oder Alkennitrilen mit Anthracen in Gegenwart von Lewissäuren, anschliessende Oxidation zum Anthrachinon (mit z.B. Jones-Reagenz) und nachfolgende Hydrolyse hergestellt werden.

In der JP-OS 55-89245 ist die Umsetzung von 2-Halogenanthrachinon, wobei Halogen bevorzugt F, Cl oder Br ist, mit gegebenenfalls monoalkylierten Malonsäuredialkylestern in Gegenwart von starken Basen beschrieben. Die Hydrolyse der (Anthrachino-2-yl)-malonsäurediester und die anschliessende Decarboxylierung führt zu (Anthrachino-2-yl)-essigsäure bzw. -2-alkyl-essigsäuren.

Es wurde gefunden, dass die Umsetzung von 2-Halogenanthrachinonen mit Malonsäuredialkylestern besonders vorteilhaft in Gegenwart von Kaliumcarbonat als Base durchgeführt werden kann. Die Umsetzung kann auch mit Cyanessigsäurealkylestern oder Malondinitril durchgeführt werden. Die Carbonsäureestergruppen können selektiv unter Erhalt der Nitrilgruppen oder vollständig zu Carbonsäuregruppen hydrolysiert werden. Mit oder nach der Hydrolyse kann eine Decarboxylierung erfolgen. Die so hergestellten Carbonsäuren können in der erfindungsgemässen Zusammensetzung verwendet werden.

Die so herstellbaren Ester und Nitrile können auch als Zwischenprodukte verwendet und weitere erfindungsgemäss zu verwendende (Anthrachino-2-yl)alkylcarbonsäuren oder -dicarbonsäuren hergestellt werden.

Hierzu kann man (Anthrachino-2-yl)acetonitril, -malondinitril, -cyanessigsäureester oder -malonsäurediester in Gegenwart einer Base, z.B. Kaliumcarbonat, mit einem entsprechenden Halogenalkan, Halogenalkannitril oder Halogenalkancarbonsäureester umsetzen. Danach können die Ester selektiv unter Erhalt der Nitrilgruppen oder vollständig mit den Nitrilgruppen zu Carbonsäuren hydrolysiert werden. Mit oder nach der Hydrolyse kann eine Carboxylierung erfolgen.

Die Reaktion von 2-Halogenanthrachinonen mit Malonestern bzw. Nitrilen wird vorteilhaft bei Temperaturen von 20 bis 200, vorzugsweise 20 bis 150° C durchgeführt. Als Lösungsmittel können z.B. Sulfone oder N-alkylierte Säureamide verwendet werden. Beispiele sind Dimethylsulfoxid, Tetramethylensulfon, Dimethylformamid, Dimethylacetamid und N-Methylpyrrolidon.

Die selektive Hydrolyse wird zweckmässig in alkoholischer Lösung in Gegenwart von Alkalimetallhydroxiden, z.B. KOH oder NaOH, vorgenommen. Eine vollständige Hydrolyse einschliesslich oder Nitrilgruppen erzielt man in wässrig-alkalischer oder wässrig-saurer Lösung. Die Decarboxylierung wird üblicherweise bei erhöhten Temperaturen, z.B. 100-200° C, durchgeführt.

Ein weiterer Gegenstand der Erfindung sind Anthrachinone der Formel Ia

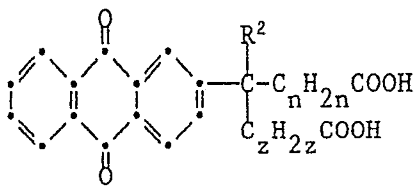

(Ia),

worin $R^2$ H oder -CN bedeutet, n für 0 oder für eine Zahl von 1 bis 12 steht und z eine Zahl von 1 bis 12 darstellt, sowie ein Verfahren zu deren Herstellung, das dadurch gekennzeichnet ist, dass man

a) wenn n 0 bedeutet, einen (Anthrachino-2-yl)-malonsäureester der Formel IV

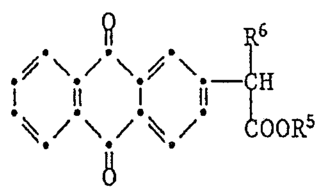

(IV),

worin $R^5O$- der Rest eines einwertigen Alkohols ist und $R^6$ -CN oder $-COOR^5$ bedeutet, in Gegenwart einer Base mit einem Halogencarbonsäureester der Formel $Y-C_zH_{2z}-COOR^5$, worin Y Cl oder Br bedeutet, umsetzt und darauf zur Herstellung von Verbindungen der Formel Ia mit $R^2$ in der Bedeutung -CN die Estergruppe hydrolysiert oder zur Herstellung der Verbindungen der Formel Ia mit $R^2$ in der Bedeutung H die Estergruppe und die Nitrilgruppe hydrolysiert und das Reaktionsprodukt decarboxyliert, oder

b) wenn $n > 0$ ist, (Anthrachino-2-yl)acetonitril in Gegenwart einer Base mit 2 Mol $Y-C_zH_{2z}-COOR^5$ oder 1 Mol $Y-C_zH_{2z}-COOR^5$ und 1 Mol $Y-C_nH_{2n}-COOR^5$ umsetzt und dann wie zuvor unter a) angegeben weiterverfährt.

$R^5$ ist bevorzugt $C_1$-$C_4$-Alkyl und besonders Ethyl oder Methyl. In den Verbindungen der Formel Ia sind die Gruppen $C_nH_{2n}$ bevorzugt linear. Bevorzugt steht n für 0 oder eine Zahl von 1 bis 6, und bevorzugt steht z für eine Zahl von 1 bis 6. Insbesondere sind n 0, 1, 2 oder 3 z 1, 2 oder 3. Die Dicarbonsäuren der Formel I verleihen den gehärteten erfindungsgemässen Zusammensetzungen eine hohe Lichtempfindlichkeit, obwohl die Dicarbonsäuren in das polymere Netzwerk eingebaut werden.

Die Anthrachinone der Formeln I und Ia eignen sich zur Herstellung von gehärteten lichtempfindlichen Epoxidharzen.

Das Epoxidharz enthält bevorzugt durchschnittlich mindestens 2 Epoxidgruppen im Molekül.

Als Epoxidharze kommen vor allem solche mit durchschnittlich mehr als einer an ein Heteroatom (z.B.

Schwefel, vorzugsweise Sauerstoff oder Stickstoff) gebundenen Glycidylgruppe, β-Methylglycidylgruppe oder 2,3-Epoxycyclopentylgruppe in Frage; genannt seien insbesondere Bis-(2,3-epoxycyclopentyl)-ether; Di- bzw. Polyglycidylether von mehrwertigen aliphatischen Alkoholen, wie 1,4-Butandiol oder Polyalkylenglykolen, wie Polypropylenglykole; Di- oder Polyglycidylether von cycloaliphatischen Polyolen, wie 2,2-Bis-(4-hydroxycyclohexyl)-propan; Di-bzw. Polyglycidylether von mehrwertigen Phenolen, wie Resorcin, Bis-(p-hydroxyphenyl)-methan, 2,2-Bis-(p-hydroxyphenyl)-propan (= Diomethan), 2,2-Bis-(4'-hydroxy-3',5'-dibromphenyl)-propan, 1,1,2,2-Tetrakis-(p-hydroxyphenyl)-ethan, oder von unter sauren Bedingungen erhaltenen Kondensationsprodukten von Phenolen mit Formaldehyd wie Phenol-Novolake und Kresol-Novolake; Di- bzw. Poly-(β-methylglycidyl)-ether der oben angeführten mehrwertigen Alkohole oder mehrwertigen Phenole; Polyglycidylester von mehrwertigen Carbonsäuren, wie Phthalsäure, Terephthalsäure, $\Delta^4$-Tetrahydrophthalsäure und Hexahydrophthalsäure; N-Glycidylderivate von Aminen, Amiden und heterocyclischen Stickstoffbasen, wie N,N-Diglycidylanilin, N,N-Diglycidyltoluidin, N,N,O-Triglycidyl-p-aminophenol, N,N,N',N'-Tetraglycidyl-bis-(p-aminophenyl)-methan; Triglycidyl-isocyanurat; N,N'-Diglycidylethylenharnstoff; N,N'-Diglycidyl-5, 5-dimethylhydantoin, N,N'-Diglycidyl-5-isopropyl-hydantoin, N,N-Methylen-bis-(N',N'-diglycidyl)-5,5-dimethylhydantoin, 1,3-Bis-(N-glycidyl-5,5-dimethylhydantoin)-2-glycidyloxypropan; N,N'-Diglycidyl-5,5-dimethyl-6-isopropyl-5,6-dihydro-uracil.

Eine bevorzugte Gruppe von Epoxidharzen sind glycidylierte Novolake, Hydantoine, Aminophenole, Bisphenole oder aromatische Diamine. Besonders bevorzugte Zusammensetzungen enthalten als Epoxidharz einen glycidylierten Kresolnovolak, Bisphenol-A-diglycidylether, ein mit Bisphenol-A vorverlängerten Bisphenol-A-diglycidylether, Hydrantoin-N,N'-bisglycid, 1,3-Bis-(N-glycidyl-5,5-dimethylhydantoin)-2-glycidyloxypropan, p-Aminophenoltriglycid, Diaminodiphenylmethan-tetraglycid oder Mischungen hiervon.

Geeignet sind auch vorreagierte Addukte solcher Epoxide mit Härtern für Epoxide, z.B. das erwähnte Addukt aus Bisphenol-A-diglycidylether und Bisphenol-A.

Als Härter für Epoxidharze kommen saure oder basische Verbindungen in Frage. Als geeignete Härter seien z.B. genannt: Amine wie aliphatische, cycloaliphatische oder aromatische, vorzugsweise primäre und/oder sekundäre Amine, z.B. Ethylendiamin, Hexamethylendiamin, Trimethylhexamethylendiamin, Diethylentriamin, Triethylentetramin, Tetraethylenpentamin, N,N-Dimethylpropylen-1,3-diamin, N,N-Diethylpropylendiamin-1,3, 2,2-Bis-(4'-aminocyclohexyl)-propan, 3,5,5-Trimethyl-3-(aminomethyl)-cyclohexylamin ("Isophorondiamin"), m-Phenylendiamin, p-Phenylendiamin, Bis-(4-aminophenyl)-methan, Bis-(4-aminophenyl)-sulfon, m-Xylylendiamin; Addukte von Acrylnitril oder Monoepoxiden, wie z.B. Ethylenoxid oder Propylenoxid an Polyalkylenpolyamine, wie z.B. Diethylentriamin oder Triethylentetramin; Addukte aus Polyaminen, wie z.B. Diethylentriamin oder Triethylentetramin, im Ueberschuss und Polyepoxiden, wie z.B. Diomethanpolyglycidylethern; Addukte aus Monophenolen oder Polyphenolen und Polyamiden; Polyamide, insbesondere solche aus aliphatischen Polyaminen, wie z.B. Diethylentriamin oder Triethylentetramin, und di- oder trimerisierten ungesättigten Fettsäuren, wie z.B. dimerisierte Leinölfettsäure (VERSAMID®); Polysulfide (THIOKOL®); Anilin-Formaldehyde; mehrwertige Phenole, z.B. Resorcin, 2,2-Bis-(4-hydroxyphenyl)-propan oder Phenol-Formaldehyd-Harze; mehrbasische Carbonsäuren und ihre Anhydride, z.B. Phthalsäureanhydrid, $\Delta^4$-Tetrahydrophthalsäureanhydrid, Hexahydrophthalsäureanhydrid, 4-Methylhexahydrophthalsäureanhydrid, 3,6-Endomethylen-$\Delta^4$-tetrahydrophthalsäureanhydrid, 4-Methyl-3,6-endomethylen-$\Delta^4$-tetrahydrophthalsäureanhydrid (= Methylnadicanhydrid), 3,4,5,6,7-Hexachlor-3,6-endomethylen-$\Delta^4$-tetrahydrophthalsäureanhydrid, Bernsteinsäureanhydrid, Adipinsäureanhydrid, Trimethyladipinsäureanhydrid, Azelainsäureanhydrid, Sebacinsäureanhydrid, Maleinsäureanhydrid, Dodecylbernsteinsäureanhydrid; Pyromellitsäuredianhydrid, Trimellitsäureanhydrid, Benzophenontetracarbonsäuredianhydrid oder Gemische solcher Anhydride.

Eine bevorzugte Gruppe von Härtern sind Novolake, Polyaminoamide und Carbonsäureanhydride. Die erfindungsgemässe Zusammensetzung kann auch Härtungsbeschleuniger bzw. Epoxidharzpolymerisationskatalysatoren oder thermische bzw. photochemische Härtungskatalysatoren enthalten. Beispiele sind: tertiäre Amine oder quaternäre Ammoniumverbindungen, z.B. Mannichbasen wie 2,4,6-Tris-(dimethylaminomethyl)phenol, Benzyldimethylamin, 2-Ethyl-4-methylimidazol, Triamylammoniumphenolat; Mono- oder Polyphenole wie Phenol oder Diomethan oder Salicylsäure; Dicyandiamid; Bortrifluorid und sein Komplexe mit organischen Verbindungen, wie $BF_3$-Ether-Komplexe und $BF_3$-Amin-Komplexe, z.B. $BF_3$-Monoethylamin-Komplex; Acetoacetanilid-$BF_3$-Komplex; Phosphorsäure; Triphenylphosphit. Bevorzugt sind tertiäre Amine und Imidazole. Als photoempfindliche Härtungsbeschleuniger eignen sich Oniumsalze oder Metallkomplexesalze wie z.B. Diazoniumsalze aromatischer Amine, Triphenylsulfonium- oder Diphenyliodoniumsalze oder Cyclopentadienyleisen-aren-salze.

Härtungsbeschleuniger und -katalysatoren werden üblicherweise in einer Menge von 0,1-10 Gew.-% zugegeben, bezogen auf das Epoxidharz. Härter für Epoxidharze werden im allgemeinen in äquimolaren Mengen verwendet, bezogen auf die Epoxidgruppen und funktionellen Gruppen eines Härters.

Die Zusammensetzung enthält das Anthrachinon der Formel I bevorzugt in einer Menge von 0,1-1, besonders 0,2-0,8 Mol/kg Epoxidharz, und das Hydroxylgruppen enthaltende Amin bevorzugt in einer Menge von 0,1-1.2, besonders 0,3-1 Mol/kg Epoxidharz. Zusätzliche Härter sind bevorzugt in einer Menge von 0,1-0,5, besonders 0,1-0,3 Mol/kg Epoxidharz enthalten.

Wenn es sich beim Anthrachinon der Formel I um eine Monocarbonsäure handelt, verwendet man vorteilhaft ein Epoxidharz mit durchschnittlich mindestens 3 Epoxidgruppen im Molekül. Bei den Aminen der Komponente d) kann es sich um Hydroxylgruppen enthaltende aliphatische Amine mit 2 bis 30, vorzugsweise 2 bis 20 C-Atomen mit 1 bis 3, vorzugsweise 1 Hydroxylgruppen im aliphatischen Rest handeln.

Der aliphatische Rest kann linear oder verzweigt sein und durch -0- oder Aminogruppen unterbrochen sein. Bevorzugt enthält der aliphatische Rest primäre OH-Gruppen. In einer bevorzugten Ausführungsform entspricht das Amin der Formel III

$$H-N(R^7)-C_yH_{2y+1-x}(OH)_x \qquad (III),$$

worin $R^7$ H, lineares oder verzweigtes $C_1$-$C_{18}$-Alkyl, $C_3$-$C_7$-Cycloalkyl, $C_6$-$C_{10}$-Aryl, $C_7$-$C_{18}$-Alkaryl, $C_7$-$C_{12}$-Aralkyl, $C_8$-$C_{18}$-Alkaralkyl oder die Gruppe $-C_yH_{2y+1-x}OH_x$ bedeutet, x für eine Zahl von 1 bis 3 und y für eine Zahl von 2 bis 12 stehen, wobei die Gruppe $C_yH_{2y}$ durch ein oder mehrere -O- oder $-NR^7$-unterbrochen sein kann.

$R^7$ enthält als Alkyl bevorzugt 1 bis 12 und besonders 1 bis 6 C-Atome. $R^7$ ist als Alkyl bevorzugt Methyl oder Ethyl. Insbesondere stellt $R^7$ H dar. Als Cycloalkyl enthält $R^7$ vorzugsweise 5 oder 6 Ring-C-Atome und ist z.B. Cyclopentyl oder Cyclohexyl.

$R^7$ kann in der Bedeutung von Aryl z.B. Naphthyl und besonders Phenyl sein. $R^7$ in der Bedeutung von Alkaryl ist besonders $C_7$-$C_{18}$-Alkylphenyl, zum Beispiel Methyl-, Ethyl-, Dimethyl-, n- und i-Propyl-, n-, i- und t-Butyl-, Pentyl-, Hexyl-, Octyl-, Nonyl-, Decyl- und Dodecylphenyl. Bei $R^7$ in der Bedeutung von Aralkyl kann es sich um 1-oder 2-Phenyleth-1-yl oder besonders Benzyl handeln. Wenn $R^7$ Alkaralkyl ist, handelt es sich bevorzugt um Alkylbenzyl mit insbesondere 8 bis 14 C-Atomen, z.B. Methyl-, Ethyl-, Dimethyl-, n-und i-Propyl-, n-, i- und t-Butyl-, Pentyl- und Hexylbenzyl. Sofern die Gruppe $C_yH_{2y}$ durch -O- unterbrochen ist, kann es sich um Oxaalkylenreste handeln, die z.B. der Formel $-R^8-(OR^9)_t-$ entsprechen können, worin $R^8$ und $R^9$ unabhängig voneinander lineares oder verzweigtes $C_2$-$C_6$-Alkylen und t eine Zahl von 2 bis 6 sind. Sofern die Gruppe $C_yH_{2y}$ durch $-NR^7$- unterbrochen ist, kann die Gruppe vorzugsweise der Formel - $-(-R^{10}-NH-)_s-R^{11}-$ entsprechen, worin $R^{10}$ lineares oder verzweigtes $C_2$-$C_6$-Alkylen, bevorzugt Ethylen, $R^{11}$ lineares oder verzweigtes $C_1$-$C_{10}$-, vorzugsweise $C_2$-$C_6$-Alkylen und s eine Zahl von 1 bis 3 sind. In Formel III steht y besonders für eine Zahl von 2 bis 7.

Eine bevorzugte Untergruppe sind solche Amine der Formel III, worin $R^7$ für H steht, y eine Zahl von 2 bis 7 und x eine Zahl von 1 bis 3 bedeuten.

Beispiele für Amine der Formel III sind: Ethanolamin, 1-Amino-2-hydroxypropan, 1-Amino-3-hydroxypropan, 1-Amino-4-hydroxybutan, 1-Amino-5-hydroxypentan, 1-Amino-6-hydroxyhexan, Aminotrimethylolmethan, Aminodimethylolmethan, Aminomethyldimethylolmethan, Aminomethyltrimethylolmethan, Hydroxyethoxyethylamin, Hydroxypropoxyethylamin, N-(Hydroxyethyl)ethylendiamin, N-(Hydroxyethyl)-diethylentriamin, $H_2N(CH_2CH_2O-)_{\overline{2-6}}$ H.

Primäre aliphatische Hydroxylgruppen enthaltende Amine sind Härter für Epoxidharze, wobei lineare Polymere erhalten werden, wenn Epoxidharze mit 2 Epoxidgruppen im Molekül verwendet werden. Bei Mitverwendung anderer Härter werden vernetzte Polymere erhalten.

Bei Verwendung der monofunktionellen Anthrachinone der Formel I werden vorteilhaft Epoxidharze mit mindestens 3 Epoxidgruppen im Molekül verwendet, z.B. epoxidierte Novolake, um vernetzte Epoxidharze zu erhalten.

Die erfindungsgemässen Zusammensetzungen sind härtbar, wobei die gehärteten bzw. vernetzten Epoxidharze lichtempfindlich sind. Auf den belichteten Stellen der Oberfläche können durch stromlose Metallabscheidung dünne Schichten von Metallen wie z.B. Kupfer abgeschieden werden.

Die Härtung der Zusammensetzung erfolgt in bekannter Weise, wobei vor oder mit der Härtung eine Formgebung nach den üblichen Formgebungsverfahren möglich ist, z.B. die Herstellung von Beschichtungen auf einem Trägermaterial durch Spritzen, Streichen oder Rakeln, oder die Herstellung von Formteilen mittels Giesstechniken, oder die Herstellung von Verbundkörpern mittels Tränk- und Pressverfahren.

Das Hydroxylgruppen enthaltende Amin der Komponente d) kann in einer bevorzugten Ausführungsform mit dem Epoxidharz der Komponente a) zu Addukten vorreagiert und dann mit einem als Härter wirkenden Anthrachinon der Formel I gegebenenfalls zusammen mit Härtern für Epoxidharze vermischt und vernetzt werden. Geeignete Härter von Anthrachinonen der Formel I sind insbesondere die Dicarbonsäuren der Formel I.

Bei Verwendung von Monocarbonsäuren der Formel I kann es vorteilhaft sein, einen Härter für Epoxidharze mitzuverwenden, besonders einen Novolak-, Amin- oder Anhydridhärter. Zweckmässig wird das monofunktionelle Anthrachinon zusammen mit dem -OH enthaltenden Amin und dem Epoxid vorreagiert und darauf mit einem Härter vermischt und ausgehärtet.

Neben einer stufenweisen Härtung ist auch das Vermischen aller Komponenten und die darauffolgende Härtung möglich.

Das Vermischen der Komponenten erfolgt nach üblichen Verarbeitungsmethoden gegebenenfalls zusammen mit einem Lösungsmittel. Es können weitere für die Verarbeitung oder die Verbesserung der Eigenschaften der gehärteten Epoxidharze übliche Zusätze zugegeben werden, z.B. Weichmacher, Farbstoffe, Pigmente, Füllstoffe, Formtrennungsmittel oder H-Donoren. Für die Abscheidung von Metallen kann ein Gehalt an Metallsalzen oder Metallkomplexen der Gruppen Ib oder VIII des periodischen Systems der

Elemente vorteilhaft sein, z.B. in einer Menge von 0,01 bis 10 Gew.-%, bezogen auf die Zusammensetzung. Die Härtung wird im allgemeinen bei Temperaturen von 20 bis 200°C, besonders 50 bis 150°C vorgenommen. Die gehärteten Zusammensetzungen sind ein weiterer Gegenstand der Erfindung.

Die gehärteten Zusammensetzungen sind lichtempfindlich. Die belichteten Teile erscheinen dunkler als die unbelichteten Teile. Auf den belichteten Teilen können mit konventionellen Metallabscheidungsbädern (siehe z.B. US-PS 4 510 279), besonders solchen mit z.B. Nickel- oder Kupfersalzen, direkt Metalle abgeschieden werden. So können z.B. gedruckte Schaltungen hergestellt werden. Die belichteten Epoxidharze können auch für optische Speicher verwendet werden.

Ein weiterer Gegenstand der Erfindung ist die Verwendung einer gehärteten erfindungsgemässen Zusammensetzung zur Herstellung von metallischen Ueberzügen oder Abbildungen durch stromlose Metallabscheidung nach einer vollständigen oder teilweisen Belichtung der Oberfläche.

Die Belichtung wird bevorzugt mit UV-Licht vorgenommen. Es können beliebige Lichtquellen eingesetzt werden, wobei die Verwendung von UV-Lampen bevorzugt ist. Geeignete Lichtquellen sind z.B. Xenonlampen, Metallhalogenidlampen und besonders Quecksilberhoch- und -mitteldrucklampen.

Zur Herstellung der metallischen Ueberzüge oder Abbildungen kann man so vorgehen, dass man die erfindungsgemäss, sich gegebenenfalls als Schicht auf einem Trägermaterial befindliche erfindungsgemässe Zusammensetzung härtet, darauf flächenmässig oder durch eine Bildvorlage belichtet und danach mit einem Metallabscheidungsbad behandelt.

Die Mitverwendung eines Metallsalzes oder Metallkomplexes ist überflüssig. Die abgeschiedenen Metalle haften fest auf der Epoxidharzoberfläche; eine Vorbehandlung ist nicht notwendig. Ferner weisen die gehärteten Zusammensetzungen erhöhte Glasumwandlungstemperaturen auf.

Die nachfolgenden Beispiele erläutern die Erfindung näher.

## A) Herstellungsbeispiele

### Beispiel 1: (Anthrachino-2-yl)-bernsteinsäure

#### a) (Anthrachino-2-yl)-malonsäurediethylester

48,53 g (200 mMol) 2-Chloranthrachinon, 160,17 g (1 Mol) Malonsäurediethylester und 500 ml Dimethylsulfoxid (DMSO) werden auf 120°C erwärmt, bis alles gelöst ist. Dann wird auf 110°C gekühlt und portionenweise 165,85 g (1,2 Mol) Kaliumcarbonat zugegeben. Nach 1 Tag Rühren bei 110°C wird das Gemisch abgekühlt, mit HCl-Lösung versetzt und dreimal mit Toluol extrahiert. Die Extrakte werden dreimal mit Wasser gewaschen, über Natriumsulfat getrocknet und eingedampft. Durch Filtrieren mit Toluol über Kieselgel und Umkristallisieren aus Methylenchlorid/Pentan werden 38,53 g (53 %) reines Produkt erhalten, Schmelpunkt: 114-117°C.

Elementaranalyse (Gew.-%)
Berechnet:
C 68,85 , H 4,95 , O 26,20%.
Gefunden:
C 68,77 , H 5,14 , O 25,89 %.

#### b) 2-(Anthrachino-2′-yl)-2-carboethoxy-bernsteinsäurediethylester

20,0 g (54,6 mMol) Verbindung 1a werden mit 22,63 g (164 mMol) Kaliumcarbonat, 18,23 g (109,2 mMol) Bromessigsäureethylester und 200 ml DMSO während 1 Stunde bei 25°C gerührt. Das Gemisch wird mit Toluol und verdünnter HCl-Lösung versetzt. Durch zweimaliges Extrahieren der Wasserphase mit Toluol, Waschen der Toluolphasen mit Wasser, Trocknen über Natriumsulfat und Eindampfen erhält man einen kristallinen Rückstand, der nach Verrühren mit Diethylether, Abfiltrieren und Trocknen 19,77 g (80 %) reines Produkt ergibt, Schmelzpunkt: 80-84°C.

Elementaranalyse (Gew.-%)
Berechnet:
C 66,36 , H 5,35 , O 28,29 %.
Gefunden:
C 66,65 , H 5,40 , O 28,54 %.

#### c) (Anthrachino-2-yl)-bernsteinsäure

16,35 g (292 mMol) Kaliumhydroxid werden in 400 ml absolutem Ethanol gelöst und 22,0 g (48,6 mMol) Verbindung 1b zugegeben. Das Gemisch wird während 20 Minuten bei 25°C gerührt und dann während 30 Minuten zum Rückfluss erhitzt. Nach dem Abkühlen wird mit 2N wässriger HCl-Lösung versetzt und mit

THF/Toluol (1:1) extrahiert. Die organischen Phasen werden über Natriumsulfat getrocknet und eingedampft. Durch Verrühren mit Diethylether, Abfiltrieren und Trocknen erhält man 15,51 g (98 %) reines Produkt, Schmelzpunkt: 245-250° C (Zersetzung).

Elementaranalyse (Gew.-%)
Berechnet:
C 66,67 , H 3,73 , O 29,60 %.
Gefunden:
C 66,98 , H 4,02 , O 28,83 %.

Beispiel 2: (Anthrachino-2-yl)bernsteinsäure

a) (Anthrachino-2-yl)-malonsäuredimethylester

12,14 g (50 mMol) 2-Chloranthrachinon, 33,03 g (250 mMol) Malonsäuredimethylester und 125 ml DMSO werden bei 110° C gerührt. Nach 14 Stunden bei 110° C wird das Gemisch am Rotationsverdampfer bei 95° C/17 mbar eingedampft. Der Rückstand wird in Methylenchlorid/verdünnter HCl-Lösung aufgenommen, die organischen Phasen über Natriumsulfat getrocknet und eingedampft. Nach Filtration über Kieselgel (Laufmittel: 3 % Aceton in $CH_2Cl_2$) und Umkristallisation aus $CH_2Cl_2$/Pentan werden 13,99 g (82 %) Produkt enthalten, Schmelzpunkt: 149-153° C.

Elementaranalyse (Gew.-%)
Berechnet:
C 67,46 , H 4,17 %.
Gefunden:
C 67,62 , H 4,20 %.

b) 2-(Anthrachino-2'-yl)-2-carbomethoxy-bernsteinsäure-1-methyl-4-ethylester

1,01 g (3 mMol) (2-Anthrachinonyl-)malonsäuredimethylester, 668 mg (4 mMol) Bromessigsäureethylester, 533 mg (4 mMol) Kaliumcarbonat und 6 ml DMSO werden 90 Minuten bei 25° C gerührt. Nach zu Beispiel 1b analoger Aufarbeitung werden 1,21 g (95 %) Produkt erhalten, aus Methylenchlorid/Pentan umkristallisiert, Schmelzpunkt: 148-151° C.

Elementaranalyse (Gew.-%)
Berechnet:
C 65,09 , H 4,75 %.
Gefunden:
C 64,59 , H 4,66 %.

c) (Anthrachino-2-yl)-bernsteinsäure

Die zu Beispiel 1c analoge Hydrolyse [424 mg (1mMol) Verbindung 2b, 337 mg (6 mMol)KOH und 10 ml absolutes Ethanol] ergibt nach 4 Stunden bei 25° C und 1 Stunde am Rückfluss 320 mg (98 %) reines Produkt, Schmelzpunkt 240-250° C.

Beispiel 3: 3-(Anthrachino-2'-yl)-3-cyano-glutarsäure

a) (Anthrachino-2-yl)-cyanoessigsäureethylester

50,0 g (206 mMol) 2-Chloranthrachinon, 69,92 g (618 mMol) Cyanessigsäureethylester und 500 ml DMSO werden auf 120° C erhitzt, wobei Lösung eintritt. Bei 110° C werden nun 170,86 g (1236 mMol) Kaliumcarbonat portionenweise eingetragen. Nach 2 Stunden Rühren wird abfiltriert und mit $H_2O$ gewaschen. Die Kristalle werden in $CH_2Cl_2$ gelöst und die organische Phase mit Wasser gewaschen, über Natriumsulfat getrocknet und eingeengt. Aus $CH_2Cl_2$/Pentan umkristallisiert werden 60,0 g (91 %) Produkt erhalten, Schmelzpunkt 167-170° C.

Elementaranalyse (Gew.-%)
Berechnet:
C 71,47 , H 4,11 , N 4,39 , O 20,04 %.
Gefunden:
C 70,93 , H 4,39 , N 4,17 , O 20,06 %.

b) (Anthrachino-2-yl)-acetonitril

50 g Verbindung a) werden mit 500 ml DMSO und 50 ml $H_2O$ während 1 Stunde auf 130°C erhitzt. Das Gemisch wird abgekühlt und auf 2 l Eis/Wasser ausgetragen. Der Niederschlag wird abfiltriert, mit Wasser gewaschen und bei 150°C im Vakuum getrocknet. Nach Verrühren in Diethylether werden 34,3 g (89 %) (2-Anthrachinoyl)acetonitril erhalten. Schmelzpunkt 212-215°C.

Elementaranalyse (Gew.-%)
Berechnet:
C 77,72 , H 3,67 , N 5,66 %.
Gefunden:
C 77,40 , H, 3,76 , N 5,73 %.

c) 3-(Anthrachino-2′-yl)-3-cyanoglutarsäurediethylester

10 g (40,44 mMol) Verbindung 3b, 20,26 g (121,33 mMol) Bromessigsäureethylester, 16,8 g (121,33 mMol) Kaliumcarbonat und 100 ml DMSO werden 90 Minuten bei 25°C gerührt. Das Gemisch wird in verdünnter HCl-Lösung/ Toluol aufgenommen, die Toluolphase mit Wasser gewaschen, über Natriumsulfat getrocknet und eingedampft. Durch Umkristallisation aus $CH_2Cl_2$/Pentan werden 12,77 g (75 %) reines produkt erhalten, Schmelzpunkt 125-126°C.

Elementaranalyse (Gew.-%)
Berechnet:
C 68,73 , H 5,05 , N 3,34 , O 22,89 %.
Gefunden:
C 68,59 , H 5,16 , N 3,43 , O 22,86 %.

d) 3-(Anthrachino-2′-yl)-3-cyanoglutarsäure

12 g (28,61 mMol) Verbindung 3c, 9,63 g (171,66 mMol) Kaliumhydroxid und 120 ml Ethanol werden 2 1/2 Stunden bei 25°C gerührt. Das Gemisch wird am Rotationsverdampfer im Vakuum eingeengt und der Rückstand in 2N HCl-Lösung/THF/Toluol aufgenommen. Die organische Phase wird abgetrennt, über Natriumsulfat getrocknet und eingeengt. Durch Verrühren mit Diethylether werden 10,2 g (98 %) reines Produkt erhalten, Schmelzpunkt 166-171°C (Zersetzung).

Elementaranalyse (Gew.-%)
Berechnet:
C 66,12 , H 3,61 , N 3,86 %.
Gefunden:
C, 66,20 , H 3,68 , N 3,90 %.

Beispiel 4 : 4-(Anthrachino-2′-yl)-4-cyano-pimelinsäure

a) 4-(Anthrachino-2′-yl)-4-cyano-pimelinsäurediethylester

2,63 g (10,6 mMol) (2-Anthrachinoyl-)acetonitril, 5,78 g (31,9mMol) 3-Brompropionsäureethylester, 4,41 g (31,9mMol) Kaliumcarbonat und 26 ml DMSO werden 6 Tage bei 25°C gerührt. Das Gemisch wird in Toluol aufgenommen, die organische Phase dreimal mit Wasser, je einmal mit verdünnter HCl-Lösung, $NaHCO_3$-Lösung und gesättigter NaCl-Lösung gewaschen, über Natriumsulfat getrocknet und eingedampft. Durch Chromatographie an Kieselgel (2 % Aceton in $CH_2Cl_2$) werden 1,02 g (22 %) flüssiges Produkt erhalten.

Elementaranalyse (Gew.-%)
Berechnet:
C 69,78 , H 5,63 , N 3,13 %.
Gefunden:
C 69,61 , H 5,61 , N 3,21 %.

b) 4-(Anthrachino-2′-yl)-4-cyano-pimelinsäure

820 mg (1,83 mMol) Verbindung 4a werden in einer Lösung von 257 mg (4,58 mMol) Kaliumhydroxid in 8 ml Ethanol zuerst 6 Stunden bei 25°C und dann 30 Minuten am Rückfluss gerührt. Das Gemisch wird im Vakuum eingeengt und der Rückstand in Wasser aufgenommen, die Suspension filtriert und die Mutterlauge angesäuert. Durch Extraktion mit THF/Toluol 1:1, Waschen der organischen Phasen mit gesättigter

NaCl-Lösung, Trocknen über Natriumsulfat, Eindampfen und Umkristallisieren aus THF/Toluol werden 610 mg (85 %) Produkt erhalten, Schmelzpunkt 233-239°C.

Elementaranalyse (Gew.-%)
Berechnet:
C 67,52 , H 4,38 , N 3,58 %.
Gefunden:
C 67,24 , H 4,57 , N 3,24 %.

B) Applikationsbeispiele

Beispiele 5-10:

6.04 g (27 mVal Epoxidgruppen) eines glycidylierten Kresolnovolaks mit Epoxidäquivalent (233,71 g/mol und 2,27 g (9 mMol) 2-Anthrachinoncarbonsäure werden in 20 ml Ethylenglykolmonoethylether mit 40 ml Benzyldimethylamin auf 120° C unter Rühren und Schutzgas erhitzt. Zu dieser Lösung gibt man nach Abkühlen auf Raumtemperatur 0,676 g (9 mMol) 2-Propanolamin unter Rühren zu. Man erhält eine viskose Lösung, die im Kühlschrank aufbewahrt wird.

Die viskose Lösung wird als Film mittels Drahtrakeln auf einem Aluminium- oder Polyesterträger gegossen und im Umluftofen für 12 Stunden bei 80°C getrocknet.

In analoger Weise wurden die Beispiele 6 bis 10 hergestellt. Tabelle 1 zeigt die Eigenschaften der Polyaddukte.

Die Effizienz der Photoreduktion wird wie folgt bestimmt. Ein Film auf einem Polyesterträger mit O.D. = 1 bei 324 nm wird mit einer Hg-Hochdrucklampe mit 40 $mW/cm^{-2}$ bestrahlt und in regelmässigen Abständen das UV/VIS-Spektrum aufgenommen. Die Bande bei 324 nm nimmt ab, die Bande bei 385 nm nimmt zu. Das Verhältnis beider Banden nach 2 Minuten Belichtungszeit wird als Effizienz genommen.

Photometallisierung

Filme auf einem Polyesterträger werden auf einem thermostatisierbaren Vakuumheiztisch bei 50°C durch ein Negativ mit einer Hg-Hochdrucklampe mit 40 $mW/cm^{-2}$ Intensität belichtet. Man erhält ein dunkles, negatives Abbild der Vorlage, das in einem Abscheidungsbad, der Zusammensetzung (siehe US-PS 4510276):
$CuSO_4 \times 5H_2O$ 0,0665 Mol/l
HCOH 0,0467 Mol/l
Quadrol 0,0599 Mol/l
NaOH pH 12,6
NaCN 25 mg/l
2-Mercaptobenzthiazol 10 mg/l
bei 45°C zu einem metallischen Kupferbild verstärkt wird.

Tabelle 1

| Beispiel | Carbonsäure | | Glycidylierter Novolak | 2-Propanolamin | Tg | UV-Effizienz $O.D_{385}nm$ |
|---|---|---|---|---|---|---|
| | n | mMol | mMol | mMol | °C | $O.D_{324}nm$ |
| 5 | 0 | 3 | 9 | 3 | 116 | 0,40 |
| 6 | 0 | 2 | 9 | 3,5 | 117 | 0,51 |
| 7 | 0 | 1 | 9 | 4 | 121 | 0,53 |
| 8 | 1 | 3 | 9 | 3 | 87 | 0,39 |
| 9 | 2 | 2 | 9 | 3,5 | 104 | 0,57 |
| 10 | 3 | 1 | 9 | 4 | 117 | 0,69 |

Carbonsäure:

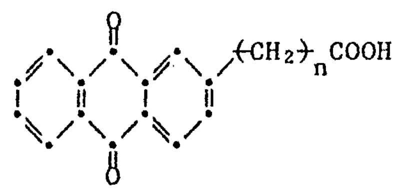

Beispiele 11-12:

173,3 g (0,5 mol) Bisphenol-A-diglycidylether wird in 180 ml Ethylenglykolmonoethylether bei 40° C gelöst. Zu dieser Lösung lässt man 15,3 g (0,25 mol) Ethanolamin unter Rühren zutropfen, steigert die Temperatur auf 60° C und lässt noch 3 Stunden reagieren. Man erhält eine viskose Lösung, die im Kühlschrank aufbewahrt wird. Das Epoxyäquivalent der Lösung beträgt 1,158 mol Epoxid/kg (bestimmt nach der Methode von R.R. Jay, Analytical Chemistry 36 (1964) 667), dies entspricht einem mittleren Molekulargewicht des Advancementprodukts von 915 Dalton (theoretisch 754 Dalton).

5 g der Lösung (5,79 mAequivalent Epoxid) wurden mit 2,85 mMol bifunktionellem Anthrachinon und 20 mg Dimethylbenzylamin als Katalysator unter Rühren und Schutzgas bei 130° C für 8 Stunden umgesetzt. Es resultiert eine viskose Lösung mit geringem Epoxidrestgehalt. Die Lösung wird als Film mittels Drahtrakeln auf Aluminium oder Polyesterträger gegossen und im Umluftofen für 12 Stunden bei 80° C getrocknet. Tabelle 2 zeigt die Eigenschaften der Polyaddukte und der Effizienz der Photoreduktion.

Tabelle 2

| Beispiel Nr. | Anthrachinonderivat<br>Einwaage (mMol) | Hydroxyalkylamin<br>Einwaage (mMol) | Epoxid<br>Einwaage (mMol) | Gehalt des Polymeren an funktionellen Gruppen in Mol/kg<br>Anthrachinon (AQ) | <br>Hydroxyl | Tg (°C) | $\frac{O.D_{385}nm}{O.D_{324}nm}$ |
|---|---|---|---|---|---|---|---|
| 11 | 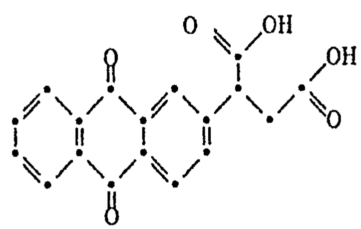<br>1 mMol | $H_2NCH_2CH_2OH$<br>1 mMol | Bisphenol-A-diglycidylether<br>3 mMol | 0,79 Mol AQ/kg | 3,98 Mol OH/kg | 59 | 0,51 |
| 12 | 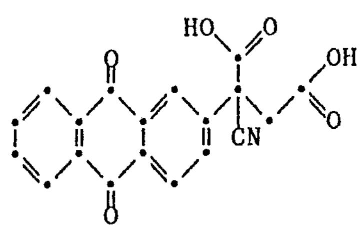<br>1 mMol | $H_2NCH_2CHCH_3$<br>OH<br>2 mMol | 3 mMol | 0,18 Mol AQ/kg | 3,44 Mol OH/kg | 97 | 0,76 |

Beispiele 13-24:

Beispiele 13-24 in Tabelle 3 zeigen den Einfluss der Vernetzung sowie des molaren Gehalts an Anthrachinoylgruppen im Netzwerk. Lineare Polyaddukte aus 2-Anthrachinonylbernsteinsäure, Bisphenol-A-diglycidylether und (Hydroxyethyl)amin werden mit einem (Beispiele 13-18) Novolak oder Carbonsäuredianhydrid vernetzt. Die Proben werden in analoger Weise wie hier für Beispiel 13 beschrieben hergestellt: 0,649 g (2 mMol) 2-Anthrachinonylbernsteinsäure, 8,177 g (23,6 mMol) Bisphenol-A-diglycidylether und 1,175 g (19,2 mMol) (Hydroxyethyl)amin werden in 10 g Diethylenglykoldimethylether 4 Stunden bei 120° C gerührt. Man lässt auf Raumtemperatur abkühlen und gibt dann 0,552 g eines Kresolnovolaks mit einem Hydroxyäquivalentgewicht von 123,15 g/Mol Hydroxyd gelöst in 0,5 g Dioxan zu. Die Lösung wird als Film mittels Drahtrakeln auf Aluminium oder Polyesterträger gegossen und im Umluftofen für 12 Stunden bei 80° C getrocknet und dann 3 Stunden bei 150° C ausgehärtet. Tabelle 3 zeigt die Eigenschaften der Polyaddukte.

Beispiele 25-28:

Tabelle 4 zeigt Einflüsse des Gehalts an -OH Gruppen sowie Art an Hydroxyalkylaminogruppen auf die Photoreduktion der Anthrachinoylgruppe. In analoger Weise wie in Beispiel 11 werden Polyaddukte mit Propanolamin, Hexanolamin und (Trihydroxymethyl)aminomethan mit unterschiedlichem Gehalt an Hydroxyalkylamin und Bisphenol-A-diglycidylether hergestellt.

Photometallisierung

Filme der Epoxidharze gemäss den Beispielen 11-28 auf einem Polyesterträger werden auf einem thermostatisierbaren Vakuumheiztisch bei 50° C durch ein Negativ mit einer Hg-Hockdrucklampe mit 40 mW/cm$^{-2}$ Intensität belichtet. Man erhält ein dunkles, negatives Abbild der Vorlage, das wie im Beispiel 5 beschrieben zu einem metallischen Kupferbild verstärkt wird.

Tabelle 3

| Beispiel Nr. | Einwaage | | Bisphenol-A-diglycidyl-ether | Härter (mAequivalent) | Gehalt des Polymeren (mMol/kg) an | | Tg | $\frac{O.D_{385}nm}{O.D_{324}nm}$ |
|---|---|---|---|---|---|---|---|---|
| | AQ-bernsteinsäure (mMol) | Ethanolamin (mMol) | | | AQ | OH | °C | |
| 13 | 2 | 19,2 | 23,6 | 4,5 | 0,2 | 4,28 | 81,2 | 0,91 |
| 14 | 4 | 16,0 | 22,3 | 4,2 | 0,4 | 3,83 | 83 | 0,77 |
| 15 | 6 | 12,9 | 21 | 4,0 | 0,6 | 3,38 | 82 | 0,60 |
| 16 | 8 | 9,7 | 19,7 | 3,7 | 0,8 | 2,94 | 79 | 0,41 |
| 17 | 10 | 6,5 | 18,4 | 3,5 | 1,0 | 2,49 | 83 | 0,32 |
| 18 | 12 | 3,34 | 17,03 | 3,2 | 1,2 | 2,04 | 79 | 0,31 |
| 19 | 2 | 19,2 | 23,6 | 4,5 | 0,2 | | 59 | 0,93 |
| 20 | 4 | 16,0 | 22,3 | 4,2 | 0,4 | | 78 | 0,78 |
| 21 | 6 | 12,9 | 21 | 4,0 | 0,6 | | 76 | 0,62 |
| 22 | 8 | 9,7 | 19,7 | 3,7 | 0,8 | | 77 | 0,44 |
| 23 | 10 | 6,5 | 18,4 | 3,5 | 1,0 | | 73 | 0,32 |
| 24 | 12 | 3,3 | 17,0 | 3,2 | 1,2 | | 78 | 0,24 |

AQ=(Anthrachino-2-yl)

Tabelle 4

| Beispiel Nr. | Hydroxy-alkylamin | Einwaage | | | | Gehalt des Polymers an | | Tg °C | $\frac{O.D_{385}nm}{O.D_{324}nm}$ |
|---|---|---|---|---|---|---|---|---|---|
| | | AQ-bern-stein-säure (mMol) | Epoxyd (mMol) | Hydroxy-alkylamin (mMol) | Novolak-Härter (mAequi-valent) | AQ (Mol/kg) | OH (Mol/kg) | | |
| 25 | $H_2NCH_2CH_2OH$ | 3,33 | 30 | 16,7 | 20 | 0,21 | 6,32 | 98 | 0,58 |
| 26 | $H_2NC(CH_2OH)_3$ | 3,33 | 30 | 16,7 | 20 | 0,21 | 6,98 | 102 | 0,73 |
| 27 | $H_2N(CH_2)_4-OH$ | 3,33 | 30 | 16,7 | 20 | 0,22 | 5,09 | 79 | 0,77 |
| 28 | $H_2N(CH_2)_6-OH$ | 3,33 | 30 | 10 | 16,7 | 0,20 | 4,22 | 81 | 0,77 |

Beispiele 29-44:

Es wird wie in den Beispielen 5-10 verfahren. Die Zusammensetzungen und Eigenschaften sind in Tabelle 5 zusammengefasst.

Tabelle 5

| Beispiel | Anthrachinoncarbonsäure (3 mMol) | 5,5'Dimethylhydantoin-N,N'-diglycidylether (mMol) | 2-Propanolamin (mMol) | Novolak (mAequivalent) | Epoxidverbindung (mMol) | Tg (°C) | $\frac{O.D_{385}nm}{O.D_{324}nm}$ |
|---|---|---|---|---|---|---|---|
| 29 | Anthrachinon-2-carbonsäure | 2 | 6 | 0 | A (7) | 98 | 0,25 |
| 30 | Anthrachinon-2-carbonsäure | 4 | 6 | 0 | A (5) | 68 | 0,26 |
| 31 | Anthrachinon-2-carbonsäure | 7 | 6 | 0 | A (2) | 55 | 0,4 |
| 32 | Anthrachinon-2-carbonsäure | 6 | 3 | 1 | A (1) | 80 | 0,46 |
| 33 | Anthrachinon-2-carbonsäure | 7 | 6 | 0 | B (2) | 67 | 0,5 |
| 34 | 2-Anthrachinonylbernsteinsäure | 6 | 3 | 1 | B (1) | 76 | 0,6 |
| 35 | 2-Anthrachinonylbernsteinsäure | 6 | 3 | 1 | A (1) | 79 | 0,48 |
| 36 | 2-Anthrachinonylbernsteinsäure | 5 | 3 | 1 | C (2) | 69 | 0,61 |

A = glycidylierter Kresolnovolak (Epoxidäquivalent 223,71 g/Mol)

B = glycidylierter Kresolnovolak (Epoxidäquivalent 216,5 g/Mol)

C = mit Bisphenol-A vorverlängerter Bisphenol-A-diglycidylether (Epoxidäquivalent 421,9 g/Mol)

Tabelle 5 (Fortsetzung)

| Beispiel | Anthrachinoncarbonsäure (3 mMol) | 5,5'Dimethylhydantoin-N,N'-diglycidylether (mMol) | 2-Propanolamin (mMol) | Novolak (mAequivalent) | Epoxidverbindung (mMol) | Tg (°C) | $\frac{O.D_{385}nm}{O.D_{324}nm}$ |
|---|---|---|---|---|---|---|---|
| 37 | 2-Anthrachinonylbernsteinsäure | 6 | 3 | 1 | C (1) | 72 | 0,62 |
| 38 | 2-Anthrachinonylbernsteinsäure | 5 | 3 | 1 | D (2) | 76 | 0,45 |
| 39 | 2-Anthrachinonylbernsteinsäure | 6 | 3 | 1 | D (1) | 76 | 0,46 |
| 40 | 2-Anthrachinonylbernsteinsäure | 6,5 | 3 | 1 | E (0,5) | 75 | 0,49 |
| 41 | 2-Anthrachinonylbernsteinsäure | 5 | 3 | 1 | F (2) | 71 | 0,45 |
| 42 | 2-Anthrachinonylbernsteinsäure | 2 | 3 | 1 | F (5) | 73 | 0,44 |
| 43 | 2-Anthrachinonylbernsteinsäure | 4 | 3 | 1 | F (3) | 78 | 0,56 |
| 44 | 2-Anthrachinonylbernsteinsäure | 3 | 3 | 1 | F (4) | 77 | 0,55 |

D = wie C, Epoxidäquivalent 901 g/Mol

E = wie C, Epoxidäquivalent 1695 g/Mol

F = Bisphenol-A-diglycidylether

**Patentansprüche**

1. Härtbare Zusammensetzung, enthaltend

a) mindestens ein Epoxidharz mit durchschnittlich mehr als einer Epoxidgruppe im Molekül,

b) gegebenenfalls einen Härter für das Epoxidharz,

c) mindestens ein Anthrachinon der Formel I

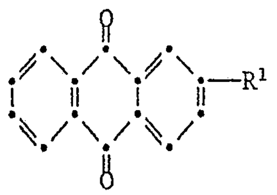

(I),

worin $R^1$ -COOH oder ein Rest der Formel II

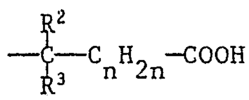

(II)

ist, in dem n 0 oder eine Zahl von 1 bis 12 bedeutet, $R^2$ H, $C_1$-$C_{12}$-Alkyl oder -CN ist und $R^3$ für H, -CN oder den Rest -$C_mH_{2m}X$ steht, m 0 oder eine Zahl von 1 bis 12 ist, und X -COOH oder -CN bedeutet, und

d) mindestens ein primäres oder sekundäres aliphatisches Amin, das im aliphatischen Rest mindestens eine Hydroxylgruppe enthält.

2. Zusammensetzungen gemäss Anspruch 1, worin

a) das Anthrachinon der Formel I in einer Menge von 0,1-1 Mol/kg Epoxidharz, und

b) das Amin in einer Menge von 0,1 bis 1,2 Mol/kg Epoxidharz enthalten sind.

3. Zusammensetzung gemäss Anspruch 1, worin als Epoxidharz glycidylierte Novolake, Hydantoine, Aminophenole, Bisphenole oder aromatische Diamine enthalten ist.

4. Zusammensetzung gemäss Anspruch 3, worin das Epoxidharz ein glycidylierter Kresolnovolak, Bisphenol-A-diglycidylether, mit Bisphenol-A vorverlängerter Bisphenol-A-diglycidylether, 5,5-Dimethylhydantoin-N,N′-bisglycidyl, 1,3-bis(N′,N′-diglycidyl-5,5-dimethylhydanto-4-yl)-2-glycidoxy-propan, p-Aminophenoltriglycid, Diaminophenylmethantetraglycid oder Mischungen hiervon ist.

5. Zusammensetzung gemäss Anspruch 1, worin der Härter b) ein Novolak, ein Polyaminoamid oder ein Polycarbonsäureanhydrid ist.

6. Zusammensetzung gemäss Anspruch 1, worin es sich bei dem Anthrachinon der Formel I um eine Monocarbonsäure handelt und das Epoxidharz a) durchschnittlich mindestens 3 Epoxidgruppen enthält.

7. Zusammensetzung gemäss Anspruch 1, worin in Formel I $R^1$ -COOH oder ein Rest der Formel II ist, in dem $R^2$ H, $C_1$-$C_6$-Alkyl oder -CN darstellt, $R^3$ für H oder den Rest -$C_mH_{2m}X$ steht, X -COOH bedeutet, und m und n unabhängig voneinander 0 oder eine Zahl von 1 bis 6 sind.

8. Zusammensetzung gemäss Anspruch 7, worin m und n unabhängig voneinander für 0 oder eine Zahl von 1 bis 4 stehen.

9. Zusammensetzung gemäss Anspruch 7, worin $R^1$ -COOH oder ein Rest der Formel II ist, in dem $R^2$ H, Methyl, Ethyl oder -CN darstellt, $R^3$ H oder den Rest -$C_mH_{2m}$COOH bedeutet, und m und n unabhängig für 0, 1, 2 oder 3 stehen.

10. Zusammensetzung gemäss Anspruch 1, worin das Amin der Komponente d) der Formel III

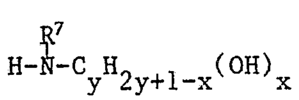

(III)

entspricht, worin $R^7$ H, lineares oder verzweigtes $C_1$-$C_{18}$-Alkyl, $C_3$-$C_7$-Cycloalkyl, $C_6$-$C_{10}$-Aryl, $C_7$-$C_{12}$-Alkaryl, $C_7$-$C_{17}$-Alkyl, $C_8$-$C_{18}$-Alkaralkyl oder die Gruppe $-C_yH_{2y+1-x}(OH)_x$ bedeutet, x für eine Zahl von 1 bis 3 und y für eine Zahl von 2 bis 12 stehen, wobei die Gruppe $C_yH_{2y}$ durch eine oder mehrere -O- oder $-NR^7$-unterbrochen sein kann.

11. Zusammensetzung gemäss Anspruch 10, worin in Formel III $R^7$ für H steht, y eine Zahl von 2 bis 7 und x eine Zahl von 1 bis 3 bedeutet.

12. Gehärtete Zusammensetzung aus

a) mindestens einem Epoxidharz mit durchschnittlich mehr als einer Epoxidgruppe im Molekül,

b) gegebenenfalls einem Härter für das Epoxidharz,

c) mindestens einem Anthrachinon der Formel I

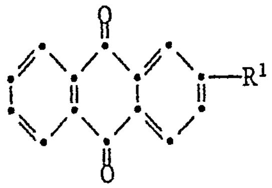 (I),

worin $R^1$ -COOH oder ein Rest der Formel II

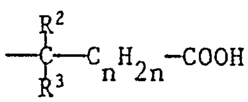 (II)

ist, in dem n 0 oder eine Zahl von 1 bis 12 bedeutet, $R^2$ H, $C_1$-$C_{12}$-Alkyl oder -CN ist und $R^3$ für H, -CN oder den Rest $-C_mH_{2m}X$ steht, m 0 oder eine Zahl von 1 bis 12 ist, und X -COOH oder -CN bedeutet, und

d) mindestens einem primären oder sekundären aliphatischen Amin, das im aliphatischen Rest mindestens eine Hydroxylgruppe enthält.

13. Verwendung einer gehärteten Zusammensetzung gemäss Anspruch 12 zur Herstellung von metallischen Ueberzügen oder Abbildungen durch stromlose Metallabscheidung nach einer vollständigen oder teilweisen Belichtung der Oberfläche.

14. Verfahren zur Herstellung von metallischen Ueberzügen oder Abbildungen auf einem Epoxidharz, bei dem man eine Zusammensetzung gemäss Anspruch 1 härtet, darauf flächenmässig oder unter einer Bildvorlage belichtet und danach mit einem Metallabscheidungsbad behandelt.

15. Anthrachinone der Formel Ia

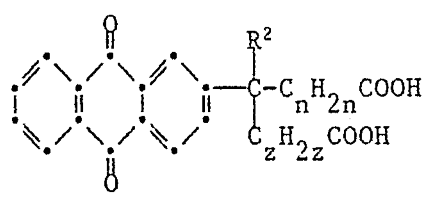 (Ia),

worin $R^2$ H oder -CN bedeutet, n für 0 oder für eine Zahl von 1 bis 12 steht und z eine Zahl von 1 bis 12 darstellt.

16. Anthrachinone gemäss Anspruch 15, worin n 0 oder eine Zahl von 1 bis 6 bedeutet und z eine Zahl von 1 bis 6 ist.

17. Anthrachinone gemäss Anspruch 15, worin n 0, 1, 2 oder 3 ist und z 1, 2 oder 3 bedeutet.

18. Verfahren zur Herstellung von Anthrachinonen der Formel Ia gemäss Anspruch 15, dadurch gekennzeichnet, dass man

a) wenn n 0 bedeutet, einen (Anthrachino-2-yl)-malonsäureester der Formel IV

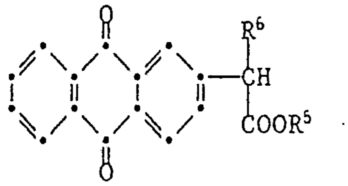

(IV),

worin $R^5O$- der Rest eines einwertigen Alkohols ist und $R^{6'}$ -CN oder $-COOR^5$ bedeutet, im Gegenwart einer Base mit einem Halogencarbonsäureester der Formel $Y-C_zH_{2z}-COOR^5$, worin Y Cl oder Br bedeutet, umsetzt und darauf zur Herstellung von Verbindungen der Formel Ia mit $R^2$ mit der Bedeutung -CN die Estergruppe hydrolysiert oder zur Herstellung der Verbindungen der Formel Ia mit $R^2$ in der Bedeutung H die Estergruppe und die Nitrilgruppe hydrolysiert und das Reaktionsprodukt decarboxyliert, oder

b) wenn $n > 0$ ist, (Anthrachino-2-yl)acetonitril in Gegenwart einer Base mit 2 Mol $Y-C_zH_{2z}-COOR^5$ oder 1 Mol $Y-C_zH_{2z}-COOR^5$ und 1 Mol $Y-C_nH_{2n}-COOR^5$ umsetzt und dann wie zuvor unter a) angegeben weiterverfährt.